# FASCICULE DE BREVET EUROPEEN

(11) **EP 3 757 735 B1**
(45) Date de publication et mention de la délivrance du brevet: **09.03.2022**
(21) Numéro de dépôt: 20180880.5
(22) Date de dépôt: 18.06.2020
(51) Int. Cl.: G06F 3/043, H01L 41/08, H01L 41/113, H01L 41/312, H01L 41/313

(54) **DISPOSITIF A SURFACE TACTILE**
VORRICHTUNG MIT TOUCH-OBERFLÄCHE
DEVICE WITH TOUCH-SENSITIVE SURFACE

(30) Priorité: 24.06.2019 FR 1906816
(43) Date de publication de la demande: 30.12.2020
(73) Titulaire: Commissariat à l'énergie atomique et aux énergies alternatives, 75015 Paris (FR)
(72) Inventeur: BENAISSA, Lamine, 38054 GRENOBLE CEDEX 09 (FR); MOULET, Jean-Sébastien, 38054 GRENOBLE CEDEX 09 (FR)
(74) Mandataire: Brevalex

(56) Documents cités:
- EP-A2- 2 631 959
- WO-A1-2015/055788
- WO-A1-2016/061155
- US-A- 5 495 137

## Description

### DOMAINE TECHNIQUE

Le domaine technique de l'invention est celui des interfaces homme-machine, ou IHM, et plus généralement celui de l'interfaçage d'espaces et/ou d'objets par le biais de fonction tactiles. L'invention peut notamment s'appliquer à la réalisation d'IHM dans le domaine de la domotique ou dans celui des environnements hostiles, par exemple en présence d'eau, d'huile, de poussières, de neige, ou exposé à des températures importantes ou faibles.

### ÉTAT DE LA TECHNIQUE ANTÉRIEURE

La plupart des solutions tactiles robustes, abordables et conformables, c'est-à-dire pouvant s'adapter à toute forme de surface à rendre tactile, font appel à des capteurs capacitifs. Un capteur capacitif est par exemple disposé en surface de la pièce ou de l'objet à fonctionnaliser, et est éventuellement recouvert d'un revêtement de faible épaisseur. Lorsque le capteur comporte une matrice d'éléments capacitifs, des fonctions tactiles avancées sont possibles, comme par exemple la détection d'un glissement de doigt (également appelé « slide » ou « swipe » en anglais) sur la surface tactile.

L'utilisation de capteurs capacitifs pour rendre une surface tactile présente toutefois plusieurs inconvénients.

Tout d'abord, la fragilité des capteurs capacitifs empêche leur intégration dans le matériau qui constitue l'objet à fonctionnaliser. Ainsi, pour une intégration optimale sur un objet, il est nécessaire de prévoir une empreinte formée en surface de l'objet pour accueillir le capteur. De plus, les techniques mises en œuvre pour solidariser le capteur sur la surface de l'objet sont limitées au collage et aux procédés froids.

Lorsque le capteur capacitif est recouvert d'un revêtement qui sert alors de surface tactile, d'autres contraintes doivent être respectées pour éviter des problèmes de diaphonie (« crosstalk » en anglais), de rapport signal/bruit trop faible, de faux positifs (déclenchements non souhaités) ou encore de pertes de sensibilité du capteur :
- restriction sur la nature des matériaux pouvant servir de revêtement et qui ne doivent pas interférer avec la détection capacitive réalisée par le capteur;
- restriction sur l'épaisseur du revêtement qui doit être inférieure à 2 mm.

Si un revêtement d'épaisseur supérieure à 2 mm doit être utilisé, le capteur est alors soumis aux contraintes suivantes:
- complexification du capteur;
- perte du caractère conformable à la pièce à fonctionnaliser ;
- élargissement de la taille des électrodes du capteur, se traduisant par une perte de résolution du capteur ;
- élargissement du design général du capteur, dégradant l'appréciation des fonctions tactiles avancées telles que le glissement de doigt sur la surface tactile.

Il existe des capteurs piézoélectriques qui permettent de rendre tactile une surface même en présence d'un revêtement ayant une épaisseur supérieure à 2 mm. Les fonctions tactiles adressables avec ces capteurs se limitent toutefois à des fonctions simples telles qu'un appui sur la surface tactile. De plus, l'utilisation d'un élément piézoélectrique non conformable limite son usage à des structures tactiles planes.

Le document WO 2015/055788 A1 divulgue un capteur sensible à la pression comprenant un substrat supportant une couche piézoélectrique en un matériau piézoélectrique, caractérisé en ce que la couche piézoélectrique présente des ondulations de surface sous la forme de rides sur lesquelles la pression est exercée lors de l'utilisation du capteur. La couche piézoélectrique est prise en sandwich entre deux électrodes pour permettre la collecte de charges générées par la déformation de la couche piézoélectrique. Les documents US 5 495 137 A, EP 2 631 959 A2 et WO 2016/061155 A1 divulguent des capteurs piézoélectriques.

### EXPOSÉ DE L'INVENTION

Un but de la présente invention est de proposer un dispositif à surface tactile ne présentant pas les inconvénients des solutions de l'art antérieur, c'est-à-dire ne présentant pas les limitations des capteurs capacitifs, dont l'épaisseur de la surface tactile ne soit pas limitée à 2 mm et qui soit adaptable à toute forme de surface tactile.

Pour cela, la présente invention propose un dispositif à surface tactile, comprenant au moins :
- un élément comprenant une première face formant la surface tactile et une deuxième face opposée à la première face ;
- un capteur d'onde acoustique comportant au moins une portion de matériau piézoélectrique disposée entre deux électrodes, la portion de matériau piézoélectrique et les deux électrodes étant structurées en formant des ondulations de surface sous la forme de rides, le capteur étant solidarisé à la deuxième face de l'élément tel que des sommets ou vallées des rides soient en contact avec la deuxième face de l'élément ;
- un circuit électronique couplé aux électrodes du capteur et configuré pour identifier, à partir d'un signal électrique destiné à être délivré depuis les électrodes du capteur, au moins un geste tactile effectué sur la surface tactile.

Dans ce dispositif, la détection d'un geste tactile par le capteur est réalisée grâce à la transmission d'ondes acoustiques dans le matériau de l'élément, ces ondes acoustiques étant détectées par le capteur et interprétées par le circuit électronique. Ce type de détection évite les inconvénients rencontrés lorsque des capteurs capacitifs sont utilisés.

Le capteur comporte des ondulations de surface, ces ondulations étant communément désignées par le terme de rides et caractérisées par une amplitude, une longueur d'onde et une orientation. Par rapport à un capteur piézoélectrique plan, c'est à dire ne comportant pas de rides, les rides apportent une plus grande capacité de déformation au capteur, et donc une plus grande sensibilité à la pression et une plus grande sensibilité de détection. L'utilisation d'un tel capteur incluant les rides permet que l'élément auquel le capteur est solidarisé ait une épaisseur supérieure à 2 mm sans que cela impacte la détection tactile réalisée, et permet la détection de gestes tactiles complexes tels que la détection d'un glissement de doigt sur la surface tactile.

De plus, les rides permettent au capteur de détecter des fonctions tactiles complexes telles qu'un glissement de doigt sur la surface tactile ou encore différents types d'appuis (long, court, avec plusieurs doigts simultanément, etc.).

Un tel dispositif a pour avantage d'être insensible aux conditions d'utilisation (chaud, froid, pluie, présence de poussière et/ou d'huile sur la surface tactile, utilisation du dispositif avec des gants, etc.) étant donné que les ondes acoustiques détectées ne sont pas impactées par ces conditions d'utilisation. Par exemple, contrairement à un capteur capacitif qui ne fonctionne plus dès l'apparition de givre en surface du capteur, lorsque le capteur est exposé à une température inférieure à 0°C, le dispositif proposé reste opérationnel même exposé à des températures inférieures à 0°C.

Ce dispositif a également pour avantage d'offrir une plus grande liberté sur le design de la surface tactile grâce à l'absence d'empreinte en surface pour accueillir le capteur et à l'absence de restriction sur la nature du ou des matériaux de l'élément formant la surface tactile (qui peut être en métal, en plastique, en bois, etc.) du fait que la constante diélectrique de l'élément n'a pas d'influence sur le capteur d'onde acoustique, contrairement à un capteur capacitif. L'élément peut avoir une géométrie complexe comprenant par exemple une ou plusieurs courbures, ou être de n'importe quelle forme (parallélépipédique, pyramidale, etc.).

Le terme « élément » est utilisé pour désigner tout type d'objet, structure ou pièce destiné à être fonctionnalisé tactilement grâce au(x) capteur(s) d'onde acoustique.

Les électrodes comportent au moins un matériau électriquement conducteur, par exemple au moins un métal.

De manière avantageuse, les rides du capteur peuvent être rectilignes et parallèles entre elles. De telles rides sont bien adaptées pour une détection d'un glissement d'un doigt, sur la surface tactile, selon une direction sensiblement perpendiculaire à l'orientation des rides.

De manière avantageuse, le matériau piézoélectrique peut correspondre à un matériau céramique, c'est-à-dire inorganique. Un tel matériau piézoélectrique a pour avantage de bien supporter les hautes températures (c'est-à-dire supérieures à environ 300°C), contrairement aux matériaux piézoélectriques polymères. L'utilisation d'un matériau piézoélectrique céramique permet notamment d'intégrer le capteur dans un élément réalisé par thermoformage ou tout autre procédé impliquant la mise en oeuvre d'étapes à des températures importantes.

Le capteur peut être solidarisé à la deuxième face de l'élément par l'intermédiaire d'au moins une couche de collage, ou le capteur peut être intégré dans l'élément. L'intégration du capteur dans l'élément a notamment pour avantage que le capteur n'est alors pas visible depuis l'extérieur de l'élément, et le capteur peut être protégé par l'élément au niveau de toutes ses faces.

L'élément peut former, entre les première et deuxième faces et contre le capteur, une couche d'épaisseur supérieure à 2 mm. Une telle épaisseur importante est possible étant donné l'utilisation du capteur piézoélectrique incluant les rides. Cette épaisseur importante de l'élément confère au dispositif une plus grande résistance et apporte une plus grande protection du capteur, par exemple vis-à-vis du vandalisme.

Les rides peuvent avoir une période supérieure à 10 µm. Une telle période permet d'avoir un capteur bien adapté à la détection des ondes acoustiques générées par gestes réalisés contre la surface tactile du dispositif.

Le dispositif peut comporter plusieurs capteurs d'onde acoustique solidarisés à la deuxième face de l'élément. Avec plusieurs capteurs d'onde acoustique couplés à la deuxième face de l'élément, il est possible de détecter des gestes tactiles complexes ou d'obtenir des informations complémentaires, comme par exemple la direction de glissement d'un doigt sur la surface tactile de l'élément.

Selon une première réalisation, lorsque le dispositif comporte plusieurs capteurs, la portion de matériau piézoélectrique de chaque capteur peut être distincte, c'est-à-dire séparée ou espacée, des portions de matériau piézoélectrique des autres capteurs, et les électrodes de chaque capteur peuvent être distinctes des électrodes des autres capteurs.

Selon une deuxième réalisation, lorsque le dispositif comporte plusieurs capteurs, les portions de matériau piézoélectrique de tous les capteurs peuvent être formées par une seule couche piézoélectrique continue commune à tous les capteurs, et au moins l'une des électrodes de chaque capteur peut être distincte des électrodes des autres capteurs.

Le circuit électronique peut être configuré pour identifier un glissement d'un doigt sur la surface tactile selon une direction sensiblement perpendiculaire à la direction selon laquelle s'étendent les rides.

Le capteur peut avoir une épaisseur inférieure à 100 µm. Un tel capteur peut s'adapter sur des éléments fins.

L'invention concerne également un procédé de réalisation d'un dispositif à surface tactile, comprenant les étapes suivantes :
- fournir au moins un capteur d'onde acoustique comportant au moins une portion de matériau piézoélectrique disposée entre deux électrodes, la portion de matériau piézoélectrique et les deux électrodes étant structurées en formant des ondulations de surface sous la forme de rides ;
- fournir au moins un élément comprenant une première face destinée à former la surface tactile et une deuxième face opposée à la première face ;
- solidariser le capteur à la deuxième face de l'élément tel que des sommets ou vallées des rides soient en contact avec la deuxième face de l'élément ;
- coupler les électrodes du capteur à un circuit électronique configuré pour identifier, à partir d'un signal électrique destiné à être délivré depuis les électrodes du capteur, au moins un geste tactile effectué sur la surface tactile.

Selon une première réalisation, la solidarisation du capteur à la deuxième face de l'élément peut comporter un collage du capteur contre la deuxième face de l'élément.

Selon une deuxième réalisation, la fourniture de l'élément et la solidarisation du capteur à la deuxième face de l'élément peut comporter :
- positionnement du capteur sur un support ;
- thermoformage ou moulage par injection de l'élément, au cours duquel le capteur est positionné contre la deuxième face, et à la fin duquel le capteur se retrouve intégré dans l'élément.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent respectivement une vue en coupe et une vue de dessus du capteur du dispositif à surface tactile, objet de la présente invention, selon le premier mode de réalisation ;
- la figure 3 représente un dispositif à surface tactile, objet de la présente invention, selon un premier mode de réalisation ;
- les figures 4 et 5 représentent un dispositif à surface tactile, objet de la présente invention, selon un deuxième mode de réalisation ;
- les figures 6 à 9 et 12 représentent des exemples de signaux électriques obtenus lors de gestes tactiles réalisés sur la surface tactile d'un dispositif, objet de la présente invention ;
- les figures 10 et 11 représentent un dispositif à surface tactile, objet de la présente invention, selon des variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

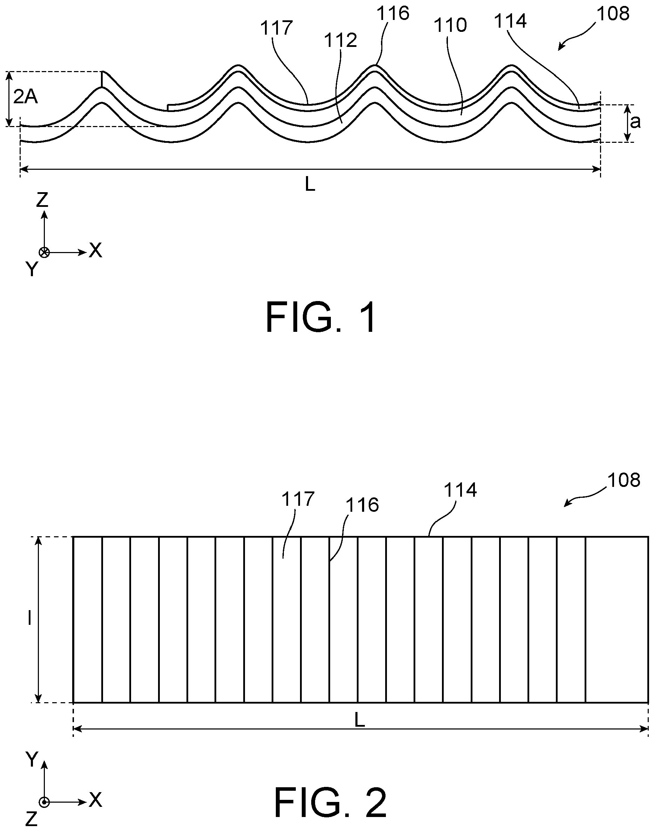

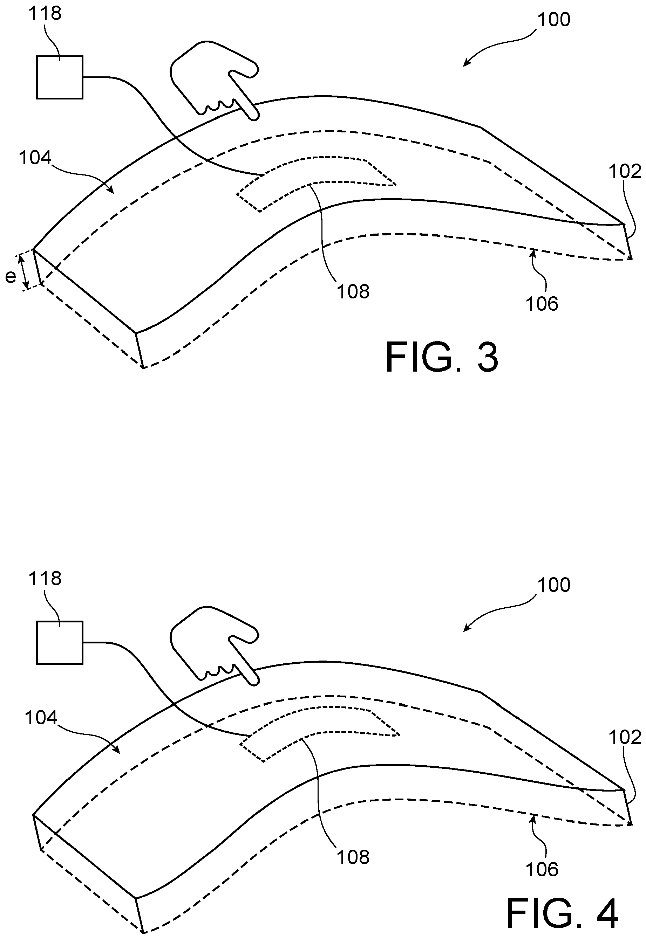

Un dispositif 100 à surface tactile selon un premier mode de réalisation est décrit ci-dessous en lien avec les figures 1 à 3. La figure 1 correspond à une vue en coupe d'un capteur 108 d'onde acoustique du dispositif 100. La figure 2 correspond à une vue de dessus du capteur 108. La figure 3 correspond à une vue en perspective du dispositif 100.

Le dispositif 100 comporte un élément 102 comprenant une première face 104. La première face 104 forme une surface tactile du dispositif 100, c'est-à-dire la surface sur laquelle des gestes tactiles (appui, glissement, etc.) sont destinés à être réalisés par un utilisateur du dispositif 100. L'élément 102 comporte également une deuxième face 106 opposée à la première face 104. L'élément 102 peut être de n'importe quelle forme. Sur l'exemple représenté sur la figure 3, l'élément 102 est courbé.

Dans le premier mode de réalisation, la distance entre les faces 104, 106, correspondant ici à l'épaisseur e de la couche formée par l'élément 102, est supérieure à 2 mm.

Le dispositif 100 comporte le capteur 108 d'onde acoustique. Le capteur 108 comporte une portion 110 de matériau piézoélectrique disposée entre deux électrodes 112, 114 assurant la collection des charges générées par effet piézoélectrique lors de la déformation du matériau piézoélectrique de la portion 110.

De manière avantageuse, le matériau piézoélectrique de la portion 110 correspond à un matériau céramique, c'est-à-dire un matériau inorganique, comme par exemple de l'AlN, du PZT, du ZnO, du LiNbO₃, du LiTaO₃, du KNbO₃, du quartz, du SrTiO₃, du BaTiO3 ou du langasite. En variante, si le matériau piézoélectrique n'est pas exposé à des températures importantes lors de la réalisation du dispositif 100, le matériau piézoélectrique peut être un polymère, comme par exemple du PVDF-TrFE).

Les électrodes 112, 114 comportent par exemple chacune un matériau métallique tel que de l'aluminium, du tungsten, du titane, du cuivre, du nickel, du platine, du palladium, de l'or, de l'argent, ou un alliage de plusieurs de ces métaux. Eventuellement, une ou chacune des électrodes 112, 114 peut être un multicouche métallique qui comprend une ou plusieurs barrières de diffusion comportant par exemple du TiN et/ou du TaN et/ou du WN. Une ou chacune des électrodes 112, 114 peut également comporter au moins un oxyde conducteur transparent correspondant par exemple à l'un des matériaux suivants : oxyde d'indium et d'étain (ITO), oxyde d'étain dopé au fluor (FTO), oxyde de zinc dopé, un polymère conducteur tel que du poly(3,4-éthylènedioxythiophène) ou PEDT, du poly(3,4-éthylènedioxythiophène) : poly(styrène sulfonate) ou PEDOT:PSS, du poly(4,4-dioctyl cyclopentadithiophène). Une ou chacune des électrodes 112, 114 peut correspondre à une couche à base d'un matériau 2D tel que du graphène ou comportant des nanotubes de carbone (CNT).

La longueur L du capteur 108 est par exemple comprise entre 1 mm et la longueur de la deuxième face 106 de l'élément 102. La largeur I du capteur 108 est par exemple comprise entre 0,5 mm et la largeur de la deuxième face 106 de l'élément 102. L'épaisseur de la portion de matériau piézoélectrique 110 est par exemple comprise entre 500 nm et 20 µm. L'électrode 112 (correspondant à l'électrode disposée du côté opposé à la deuxième face 106) peut avoir une épaisseur comprise entre environ 2 µm et 100 µm. La surface de l'électrode 112 peut être égale à celle de la portion de matériau piézoélectrique 110, ou supérieure à celle de la portion de matériau piézoélectrique 110 (une partie de l'électrode 112 pouvant être directement en contact avec l'élément 102). L'électrode 114 (correspondant à l'électrode disposée du côté de la deuxième face 106, contre l'élément 102) peut avoir une épaisseur comprise entre environ 3 nm et 2 µm. La surface de l'électrode 114 peut être comprise entre environ 50 µm x 50 µm et la surface de la portion de matériau piézoélectrique 110. L'épaisseur (notée « a » sur la figure 1) du capteur 108 (qui correspond à la somme des épaisseurs de la portion 110 et des électrodes 112 et 114) est de préférence inférieure à 100 µm. A titre d'exemple, le capteur 108 peut comporter les caractéristiques suivantes :
- longueur L = 10 mm ;
- largeur I = 3 mm ;
- épaisseur de la portion 110 = 1 µm ;
- épaisseur de l'électrode 112 (celle disposée du côté opposé à la face 106) = 4 µm ;
- épaisseur de l'électrode 114 (celle disposée du côté de la face 106, contre l'élément 102) = 50 nm.

Quelle que soit la forme de l'élément 102, le capteur 108 est disposé contre la face opposée à la surface tactile de l'élément 102.

La couche piézoélectrique 110 et les électrodes 112, 114 sont structurées en formant des ondulations de surface sous la forme de rides. Dans l'exemple de réalisation décrit ici, les rides sont rectilignes et parallèles entre elles (et parallèle à l'axe Y représenté sur la figure 1). Les rides sont réalisées avec une amplitude A, par exemple égale à 10 µm, et une période λ. De manière avantageuse, la période λ est supérieure à 10 µm, et par exemple égale à 50 µm. La valeur de la période λ est proportionnelle à celle de l'amplitude A. L'amplitude A correspondant à la moitié de la hauteur crête à crête 2A d'une même couche du capteur 108. Les sommets des rides portent la référence 116 et les vallées de rides portent la référence 117. La période λ correspond à la distance entre deux sommets 116 adjacents.

Des exemples de procédé mis en œuvre pour former le capteur 108, et plus particulièrement les rides 116, sont par exemple décrits dans les documents WO 2015/055788 A1, WO 2015/055783 A1 et WO 2015/055786 A1, et s'appliquent pour la réalisation du capteur 108 décrit ici.

Le capteur 108 est solidarisé à la deuxième face 106 de l'élément 102 tel que les sommets 116 des rides soient en contact avec la deuxième face 106. Dans le premier mode de réalisation décrit ici, le capteur 108 est solidarisé à la deuxième face 106 par collage, c'est-à-dire par l'intermédiaire d'une couche de collage (non visible sur les figures 1 à 3) interposée entre le capteur 108 et la deuxième face 106. D'autres types de collage peuvent être mis en œuvre pour la solidarisation du capteur 108 contre la deuxième face 106 de l'élément 102.

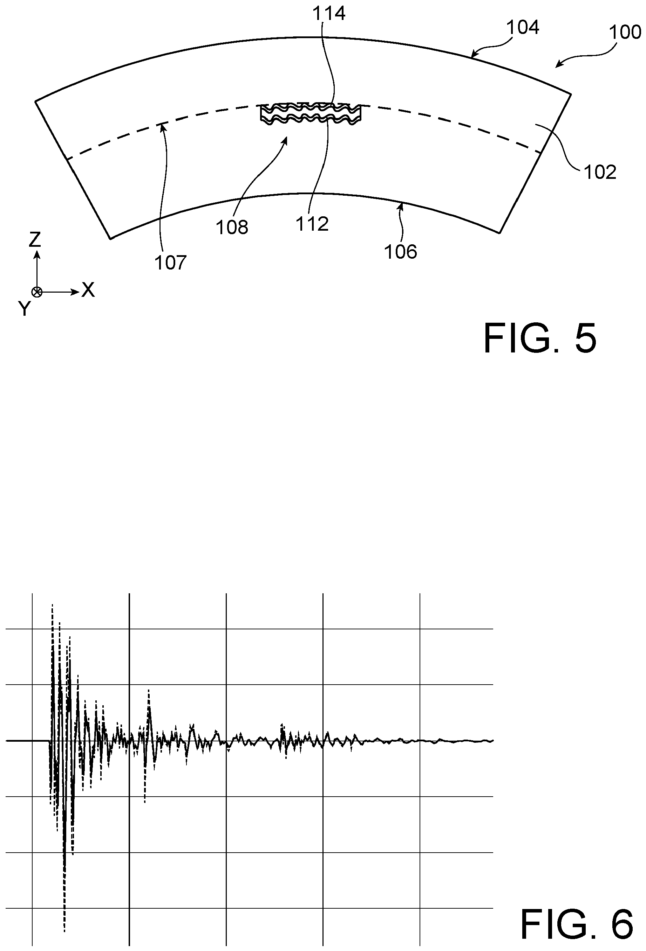

Selon un deuxième mode de réalisation, le capteur 108 est intégré dans l'élément 102 et entouré au moins partiellement par l'élément 102. Dans ce deuxième mode de réalisation, l'élément 102 est par exemple réalisé par thermoformage. Le capteur 108 est dans ce cas disposé dans l'élément 102, c'est-à-dire est entouré entièrement par le matériau de l'élément 102. La face de l'élément 102 contre laquelle le capteur 108 est disposé ne correspond pas à la deuxième face 106 formant une face extérieure de l'élément 102 mais correspond à une face référencée 107 formée au sein de, c'est-à-dire à l'intérieur de, la portion du matériau de l'élément 102 et contre laquelle l'électrode 114 est disposée. Les figures 4 et 5 représentent schématiquement le dispositif 100 selon ce deuxième mode de réalisation.

Selon un troisième mode de réalisation, le capteur 108 peut être intégré contre ou dans un élément intermédiaire de manière analogue à l'intégration précédemment décrite selon l'un des deux modes de réalisation précédents. Cet élément intermédiaire peut être ensuite assemblé à l'élément 102 par tout moyen de fixation mécanique (comme des vis, rivets, clips de fixation etc.). Dans ce cas, le capteur 108 est bien couplé à l'élément 102 tel que des sommets ou vallées des rides soient en contact, via l'élément intermédiaire, avec la deuxième face de l'élément 102.

Dans les trois modes de réalisation décrits précédemment, le dispositif 100 comporte également un circuit électronique 118 relié aux électrodes 112, 114 du capteur 108. Le circuit 118 est configuré pour identifier, à partir des signaux électriques délivrés par le capteur 108 depuis les électrodes 112, 114, un ou plusieurs gestes tactiles effectués sur la surface tactile de l'élément 102, c'est-à-dire sur la première face 104. Avantageusement, le circuit électronique 118 peut être configuré pour identifier un glissement d'un doigt sur la première face 104 selon une direction sensiblement perpendiculaire à la direction selon laquelle s'étendent les rides 116. Dans le deuxième mode de réalisation, les connexions électriques reliant les électrodes 112, 114 au circuit électronique 118 traversent l'élément 102.

Outre le mouvement de glissement du doigt sur la première face 104, le dispositif 100 selon les deux modes de réalisation précédemment décrits permet d'identifier d'autres gestes tactiles effectués sur la première face 104, comme par exemple un mouvement de pression (long ou court) et de relâchement d'un ou plusieurs doigts sur la première face 104, un mouvement de contact, un mouvement de vibration, etc.

La figure 6 représente un exemple de signal électrique obtenu entre les électrodes 112, 114 du capteur 108 lors d'une vibration sur la surface tactile 104 du dispositif 100.

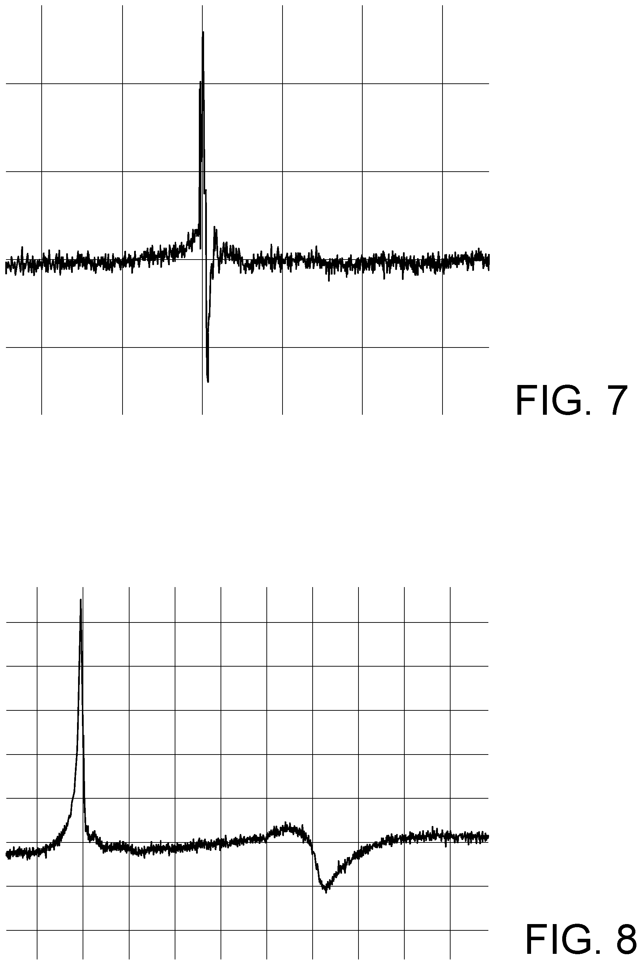

La figure 7 représente un exemple de signal électrique obtenu entre les électrodes 112, 114 du capteur 108 lors d'un appui court d'un doigt sur la surface tactile 104 du dispositif 100.

La figure 8 représente un exemple de signal électrique obtenu entre les électrodes 112, 114 du capteur 108 lors d'un appui long d'un doigt sur la surface tactile 104 du dispositif 100.

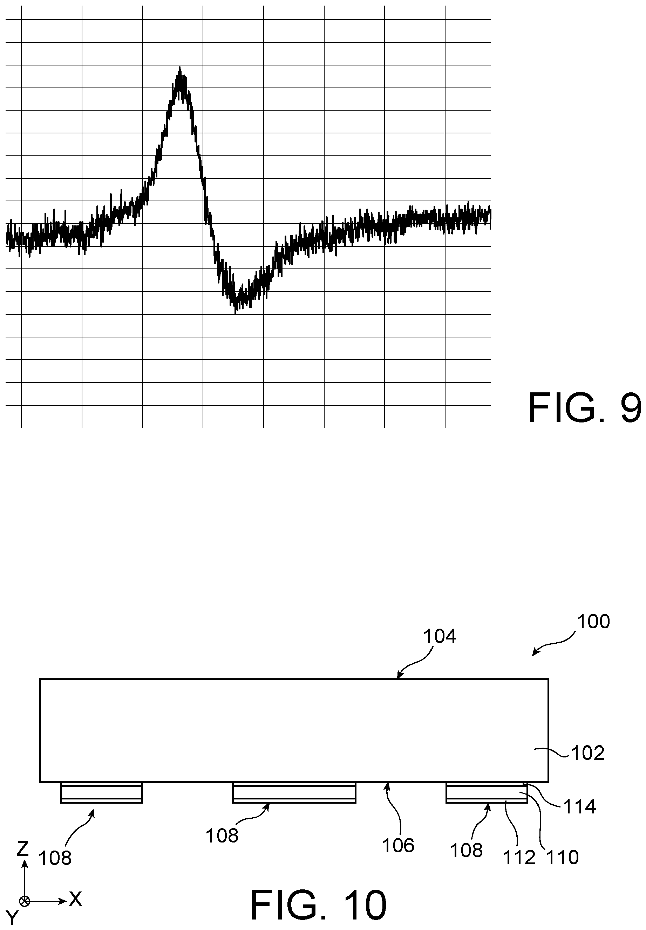

La figure 9 représente un exemple de signal électrique obtenu entre les électrodes 112, 114 du capteur 108 lors d'un glissement d'un doigt sur la surface tactile 104 du dispositif 100.

Tous ces signaux présentent des caractéristiques différentes (espaces différents entre les pics, répétitions des pics, etc.) qui sont utilisées par le circuit électronique 118, via la mise en œuvre d'un traitement de ces signaux, pour identifier le type de geste tactile réalisé sur la surface tactile du dispositif 100. Les détails de ce traitement ne sont pas décrits ici mais ce traitement peut être aisément mis en œuvre par l'homme du métier, par exemple via un traitement numérique et/ou informatique des signaux électriques délivrés sur les électrodes du ou des capteurs du dispositif 100.

Pour la réalisation du dispositif 100 selon le premier mode de réalisation, le capteur 108 et l'élément 102 sont tout d'abord réalisés indépendamment l'un de l'autre, puis le capteur 108 est disposé sur un substrat temporaire et collé contre la deuxième face 106 de l'élément 102 en utilisant par exemple une couche de collage. Le substrat temporaire peut être ensuite retiré. Les électrodes 112, 114 du capteur 108 sont ensuite couplées au circuit électronique 118.

Pour la réalisation du dispositif 100 selon le deuxième mode de réalisation, le capteur 108 est tout d'abord réalisé, puis l'élément 102 est ensuite réalisé en intégrant le capteur 108 dans l'élément 102. Pour cela, le capteur 108 peut être positionné sur un support, puis l'élément 102 peut être réalisé par thermoformage autour du capteur 108. Des ouvertures peuvent être réalisées dans l'élément 102 pour accéder aux électrodes 112, 114. Ensuite, les électrodes 112, 114 du capteur 108 sont couplées au circuit électronique 118.

Outre le thermoformage, l'élément 102 peut être réalisé par d'autres techniques selon la nature des matériaux utilisés et les caractéristiques géométriques de l'élément 102, comme par exemple : moulage, moulage par congélation (ou « freeze casting » en anglais), imprégnation ou infiltration, pyrolyse, coulage en bande, moulage par injection ou extrusion, processus de soufflage ou moussage, assemblage, jet d'encre, projection d'aérosol, dépôt, etc.

Dans les deux modes de réalisation précédemment décrits, le dispositif 100 comporte un seul capteur 108 disposé contre une deuxième face 106 ou 107 de l'élément 102. En variante, il est possible que le dispositif 100 comporte plusieurs capteurs 108 en contact avec la deuxième face 106 ou 107.

La figure 10 représente schématiquement un premier exemple de réalisation d'un dispositif 100 comportant plusieurs capteurs 108 disposés les uns à côté des autres contre la deuxième face 106 d'un même élément 102. Les capteurs 108 servent à fonctionnaliser ensemble la première face 104 de l'élément 102. Dans ce premier exemple de réalisation, les capteurs 108 comportent des portions de matériau piézoélectrique 110 et des électrodes 112, 114 distinctes d'un capteur à l'autre. Autrement dit, la portion 110 de matériau piézoélectrique de chacun des capteurs 108 est espacée et séparée des portions 110 de matériau piézoélectrique des autres capteurs 108. De même, les électrodes 112, 114 de chacun des capteurs 108 sont espacées et séparées des électrodes 112, 114 des autres capteurs 108.

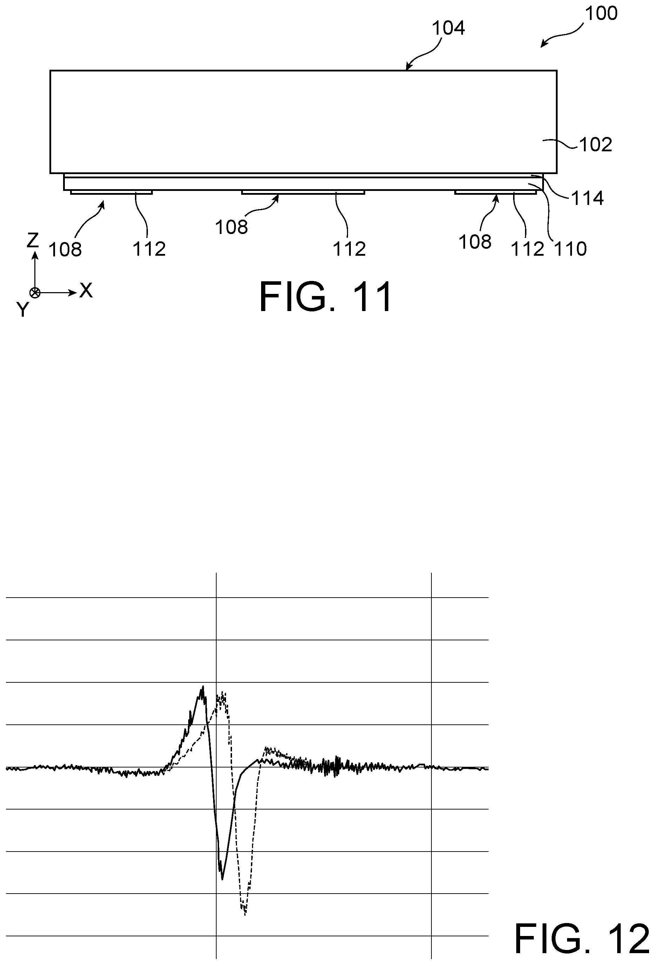

La figure 11 représente schématiquement un deuxième exemple de réalisation d'un dispositif 100 comportant plusieurs capteurs 108 disposés les uns à côté des autres contre la deuxième face 106 d'un même élément 102. Comme dans le premier exemple de réalisation, les capteurs 108 servent ensemble à fonctionnaliser la première face 104 de l'élément 102. Dans ce deuxième exemple de réalisation, les portions 110 de matériau piézoélectrique des capteurs 108 sont formées par une seule couche piézoélectrique continue commune à tous les capteurs 108. De plus, au moins l'une des électrodes 112, 114 de chaque capteur 108 est distincte des électrodes des autres capteurs 108, c'est-à-dire séparée et espacée des électrodes des autres capteurs 108. Sur l'exemple représenté sur la figure 11, l'électrode 114 de chacun des capteurs 108 est formée par une même couche de matériau électriquement conducteur continue et commune à tous les capteurs 108 (formant une électrode commune à tous les capteurs 108), et l'électrode 112 de chaque capteur 108 est formée par une portion de matériau électriquement conducteur distincte et espacée des portions de matériau électriquement conducteur formant les électrodes 112 des autres capteurs 108.

Quel que soit l'exemple de réalisation du dispositif 100, l'utilisation de plusieurs capteurs 108 associés à une même surface permet d'identifier des gestes tactiles plus complexes, comme par exemple détecter plusieurs pressions distinctes simultanées sur la surface tactile ou détecter la direction de glissement d'un doigt sur la surface tactile et sa vitesse.

Lorsque le dispositif 100 comporte plusieurs capteurs 108, les rides de ces capteurs peuvent être orientées selon une même direction ou selon des directions différentes. Par exemple, le dispositif 100 peut comporter deux capteurs 108 solidarisés à la deuxième face 106 et positionnés tels que les rides de ces deux capteurs 108 soient orientées perpendiculairement les unes par rapport aux autres. Dans ce cas, le dispositif 100 est bien adapté pour distinguer des mouvements de glissement sur la surface tactile du dispositif 100 selon deux directions perpendiculaires l'une par rapport à l'autre, par exemple un glissement selon une direction haut-bas et un glissement selon une direction gauche-droite. D'autres combinaisons de capteurs 108 sur la deuxième face 106 du dispositif 100 peuvent être envisagées.

La figure 12 représente un exemple de signaux électriques obtenus aux bornes de deux capteurs 108 d'un dispositif 100 lors d'un glissement d'un doigt sur la surface tactile de ce dispositif 100. La présence des deux capteurs 108 permet d'identifier la direction de glissement du doigt sur la surface tactile du dispositif 100 selon le décalage temporel entre les deux signaux.

Le dispositif 100 peut comporter une ou plusieurs autres pièces ou éléments auxquels l'élément 102 peut être assemblé. Le capteur 108 peut notamment être interposé entre l'élément 102 et un ou plusieurs autres éléments du dispositif 100.

La présence de plusieurs capteurs 108 sur une même surface d'un dispositif 100 est également possible lorsque le dispositif 100 correspond au deuxième mode de réalisation précédemment décrit, c'est-à-dire en intégrant les capteurs 108 dans l'élément 102 du dispositif 100.

Quel que soit l'exemple de réalisation ou le mode de réalisation, l'invention permet la fonctionnalisation d'une surface d'un objet, d'une structure ou d'une pièce avec des fonctions tactiles. Ainsi dotée de ces fonctions tactiles, la surface devient sensible à des sollicitations tactiles et peut, directement ou indirectement, déclencher une réponse à ces sollicitations. Cette réponse peut comporter un retour, ou « feedback » en anglais, haptique (par exemple tactile et/ou visuelle et/ou sonore et/ou mécanique) et/ou un déclenchement d'une ou plusieurs actions par exemple mécaniques telles qu'une ouverture/fermeture d'un système, et/ou électriques telles qu'un allumage, une extinction ou une variation lumineuse d'un système d'éclairage.

## Revendications

1. Dispositif (100) à surface tactile, comprenant au moins :
- un élément (102) comprenant une première face (104) formant la surface tactile et une deuxième face (106, 107) opposée à la première face (104) ;
- un capteur (108) d'onde acoustique comportant au moins une portion (110) de matériau piézoélectrique disposée entre deux électrodes (112, 114), la portion (110) de matériau piézoélectrique et les deux électrodes (112, 114) étant structurées en formant des ondulations de surface sous la forme de rides, le capteur (108) étant solidarisé à la deuxième face (106, 107) de l'élément (102) tel que des sommets ou vallées (116) des rides soient en contact avec la deuxième face (106, 107) de l'élément (102) ;
- un circuit électronique (118) couplé aux électrodes (112, 114) du capteur (108) et configuré pour identifier, à partir d'un signal électrique destiné à être délivré depuis les électrodes (112, 114) du capteur (108), au moins un geste tactile effectué sur la surface tactile.

2. Dispositif (100) selon la revendication 1, dans lequel les rides du capteur (108) sont rectilignes et parallèles entre elles.

3. Dispositif (100) selon l'une des revendications précédentes, dans lequel le matériau piézoélectrique correspond à un matériau céramique.

4. Dispositif (100) selon l'une des revendications précédentes, dans lequel le capteur (108) est solidarisé à la deuxième face (106) de l'élément (102) par l'intermédiaire d'au moins une couche de collage, ou dans lequel le capteur (108) est intégré dans l'élément (102).

5. Dispositif (100) selon l'une des revendications précédentes, dans lequel l'élément (102) forme, entre les première et deuxième faces (104, 106, 107) et contre le capteur (108), une couche d'épaisseur supérieure à 2 mm.

6. Dispositif (100) selon l'une des revendications précédentes, dans lequel les rides ont une période supérieure à 10 µm.

7. Dispositif (100) selon l'une des revendications précédentes, comportant plusieurs capteurs (108) d'onde acoustique solidarisés à la deuxième face (106, 107) de l'élément (102).

8. Dispositif (100) selon la revendication 7, dans lequel la portion (110) de matériau piézoélectrique de chaque capteur (108) est distincte des portions (110) de matériau piézoélectrique des autres capteurs (108), et dans lequel les électrodes (112, 114) de chaque capteur (108) sont distinctes des électrodes (112, 114) des autres capteurs (108).

9. Dispositif (100) selon la revendication 7, dans lequel les portions (110) de matériau piézoélectrique de tous les capteurs (108) sont formées par une seule couche piézoélectrique continue commune à tous les capteurs (108), et dans lequel au moins l'une des électrodes (112) de chaque capteur (108) est distincte des électrodes (112) des autres capteurs (108).

10. Dispositif (100) selon l'une des revendications précédentes, dans lequel le capteur (108) a une épaisseur inférieure à 100 µm.

11. Procédé de réalisation d'un dispositif (100) à surface tactile, comprenant les étapes suivantes :
- fournir au moins un capteur (108) d'onde acoustique comportant au moins une portion (110) de matériau piézoélectrique disposée entre deux électrodes (112, 114), la portion (110) de matériau piézoélectrique et les deux électrodes (112, 114) étant structurées en formant des ondulations de surface sous la forme de rides ;
- fournir au moins un élément (102) comprenant une première face (104) destinée à former la surface tactile et une deuxième face (106, 107) opposée à la première face (104) ;
- solidariser le capteur (108) à la deuxième face (106, 107) de l'élément (102) tel que des sommets ou vallées (116) des rides soient en contact avec la deuxième face (106, 107) de l'élément (102) ;
- coupler les électrodes (112, 114) du capteur (108) à un circuit électronique (118) configuré pour identifier, à partir d'un signal électrique destiné à être délivré depuis les électrodes (112, 114) du capteur (108), au moins un geste tactile effectué sur la surface tactile.

12. Procédé selon la revendication 11, dans lequel la solidarisation du capteur (108) à la deuxième face (106) de l'élément (102) comporte un collage du capteur (108) contre la deuxième face (106) de l'élément (102).

13. Procédé selon la revendication 11, dans lequel la fourniture de l'élément (102) et la solidarisation du capteur (108) à la deuxième face (107) de l'élément (102) comporte :
- positionnement du capteur (108) sur un support ;
- thermoformage ou moulage par injection de l'élément (102), au cours duquel le capteur (108) est positionné contre la deuxième face (107), et à la fin duquel le capteur (108) se retrouve intégré dans l'élément (102).

## Patentansprüche

1. Vorrichtung (100) mit taktiler Oberfläche, umfassend wenigstens folgendes:
- ein Element (102), umfassend eine erste Fläche (104), die die taktile Oberfläche bildet, und eine zweite Fläche (106, 107) entgegengesetzt zu der ersten Fläche (104);
- einen Akustikwellensensor (108), umfassend wenigstens einen Bereich (110) aus piezoelektrischem Material, der zwischen zwei Elektroden (112, 114) angeordnet ist, wobei der Bereich (110) aus piezoelektrischem Material und die zwei Elektroden (112, 114) derart strukturiert sind, dass sie Oberflächenwellen in der Form von Kräuselungen bilden, wobei der Sensor (108) mit der zweiten Fläche (106, 107) des Elements (102) derart verbunden ist, dass Gipfel oder Täler (116) der Kräuselungen in Kontakt mit der zweiten Fläche (106, 107) des Elements (102) sind;
- eine elektronische Schaltung (118), die mit den Elektroden (112, 114) des Sensors (108) gekoppelt und dazu konfiguriert ist, ausgehend von einem elektrischen Signal, das dazu bestimmt ist, von den Elektroden (112, 114) des Sensors (108) geliefert zu werden, wenigstens eine taktile Geste zu identifizieren, die auf der taktilen Oberfläche ausgeführt wird.

2. Vorrichtung (100) nach Anspruch 1, bei der die Kräuselungen des Sensors (108) geradlinig und zueinander parallel sind.

3. Vorrichtung (100) nach einem der vorhergehenden Ansprüche, bei der das piezoelektrische Material einem Keramikmaterial entspricht.

4. Vorrichtung (100) nach einem der vorhergehenden Ansprüche, bei der der Sensor (108) mit der zweiten Fläche (106) des Elements (102) mittels wenigstens einer Klebschicht verbunden ist, oder bei der der Sensor (108) in das Element (102) integriert ist.

5. Vorrichtung (100) nach einem der vorhergehenden Ansprüche, bei der das Element (102) zwischen der ersten und der zweiten Fläche (104, 106, 107) und gegen den Sensor (108), eine Schicht mit einer Dicke größer als 2 mm bildet.

6. Vorrichtung (100) nach einem der vorhergehenden Ansprüche, bei der die Kräuselungen eine Periode von mehr als 10µm haben.

7. Vorrichtung (100) nach einem der vorhergehenden Ansprüche, umfassend mehrere Akustikwellensensoren (108), die mit der zweiten Fläche (106,107) des Elements (102) verbunden sind.

8. Vorrichtung (100) nach Anspruch 7, bei der der Bereich (110) aus piezoelektrischem Material jedes Sensors (108) von den Bereichen (110) aus piezoelektrischem Material der anderen Sensoren (108) verschieden ist, und bei der die Elektroden (112, 114) jedes Sensors (108) von den Elektroden (112, 114) der anderen Sensoren (108) verschieden sind.

9. Vorrichtung (110) nach Anspruch 7, bei der die Bereiche (110) aus piezoelektrischem Material aller Sensoren (108) durch eine einzige durchgehende piezoelektrische Schicht gebildet sind, die allen Sensoren (108) gemeinsam ist, und bei der wenigstens eine der Elektroden (112) jedes Sensors (108) von den Elektroden (112) der anderen Sensoren (108) verschieden ist.

10. Vorrichtung (100) nach einem der vorhergehenden Ansprüche, bei der der Sensor (108) eine Dicke von weniger als 100 µm hat.

11. Verfahren zur Herstellung einer Vorrichtung (100) mit taktiler Oberfläche, umfassend die folgenden Schritte:
- Bereitstellen wenigstens eines Akustikwellensensors (108), umfassend wenigstens einen Bereich (110) aus piezoelektrischem Material, der zwischen zwei Elektroden (112, 114) angeordnet ist, wobei der Bereich (110) aus piezoelektrischem Material und die zwei Elektroden (112, 114) derart strukturiert sind, dass sie Oberflächenwellen in der Form von Kräuselungen bilden;
- Bereitstellen wenigstens eines Elements (102), umfassend eine erste Fläche (104), die dazu bestimmt ist, die taktile Oberfläche zu bilden, und eine zweite Fläche (106, 107) entgegengesetzt zu der ersten Fläche (104);
- Verbinden des Sensors (108) mit der zweiten Fläche (106, 107) des Elements (102) derart, dass Gipfel oder Täler (116) der Kräuselungen in Kontakt mit der zweiten Fläche (106, 107) des Elements (102) sind;
- Koppeln der Elektroden (112, 114) des Sensors (108) mit einer elektronischen Schaltung (118), die dazu konfiguriert ist, ausgehend von einem elektrischen Signal, das dazu bestimmt ist, von den Elektroden (112, 114) des Sensors (108) geliefert zu werden, wenigstens eine taktile Geste zu identifizieren, die auf der taktilen Oberfläche ausgeführt wird.

12. Verfahren nach Anspruch 11, bei dem das Verbinden des Sensors (108) mit der zweiten Fläche (106) des Elements (102) ein Kleben des Sensors (108) gegen die zweite Fläche (106) des Elements (102) umfasst.

13. Verfahren nach Anspruch 11, bei dem das Bereitstellen des Elements (102) und das Verbinden des Sensors (108) mit der zweiten Fläche (107) des Elements (102) umfasst:
- Positionieren des Sensors (108) auf einem Träger;
- Thermoformen oder Spritzgießen des Elements (102), in dessen Verlauf der Sensor (108) gegen die zweite Fläche (107) positioniert wird, und an dessen Ende sich der Sensor (108) in dem Element (102) integriert befindet.

## Claims

1. A touch surface device (100), comprising at least:
- an element (102) comprising a first face (104) forming the touch surface and a second face (106, 107) opposite to the first face (104);
- an acoustic wave sensor (108) including at least one portion (110) of piezoelectric material disposed between two electrodes (112, 114), the portion (110) of piezoelectric material and both electrodes (112, 114) being structured by forming surface wavinesses as wrinkles, the sensor (108) being secured to the second face (106, 107) of the element (102) such that apexes or valleys (116) of the wrinkles are in contact with the second face (106, 107) of the element (102);
- an electronic circuit (118) coupled to the electrodes (112, 114) of the sensor (108) and configured to identify, from an electric signal intended to be outputted from the electrodes (112, 114) of the sensor (108), at least one touch gesture made on the touch surface.

2. The device (100) according to claim 1, wherein the wrinkles of the sensor (108) are rectilinear and parallel to each other.

3. The device (100) according to one of the preceding claims, wherein the piezoelectric material corresponds to a ceramic material.

4. The device (100) according to one of the preceding claims, wherein the sensor (108) is secured to the second face (106) of the element (102) through at least one bonding layer, or wherein the sensor (108) is integrated into the element (102).

5. The device (100) according to one of the preceding claims, wherein the element (102) forms, between the first and second faces (104, 106, 107) and against the sensor (108), a layer with a thickness higher than 2mm.

6. The device (100) according to one of the preceding claims, wherein the wrinkles have a period higher than 10µm.

7. The device (100) according to one of the preceding claims, including several acoustic wave sensors (108) secured to the second face (106, 107) of the element (102).

8. The device (100) according to claim 7, wherein the portion (110) of piezoelectric material of each sensor (108) is distinct from the portions (110) of piezoelectric material of the other sensors (108), and wherein the electrodes (112, 114) of each sensor (108) are distinct from the electrodes (112, 114) of the other sensors (108).

9. The device (100) according to claim 7, wherein the portions (110) of piezoelectric material of all the sensors (108) are formed by a single continuous piezoelectric layer common to all the sensors (108), and wherein at least one of the electrodes (112) of each sensor (108) is distinct from the electrodes (112) of the other sensors (108).

10. The device (100) according to one of the preceding claims, wherein the sensor (108) has a thickness smaller than 100µm.

11. A method for making a touch surface device (100), comprising the following steps of:
- providing at least one acoustic wave sensor (108) including at least one portion (110) of piezoelectric material disposed between two electrodes (112, 114), the portion (110) of piezoelectric material and both electrodes (112, 114) being structured by forming surface wavinesses as wrinkles;
- providing at least one element (102) comprising a first face (104) for forming the touch surface and a second face (106, 107) opposite to the first face (104);
- securing the sensor (108) to the second face (106, 107) of the element (102) such that apexes or valleys (116) of the wrinkles are in contact with the second face (106, 107) of the element (102);
- coupling the electrodes (112, 114) of the sensor (108) to an electronic circuit (118) configured to identify, from an electric signal intended to be outputted from the electrodes (112, 114) of the sensor (108), at least one touch gesture made on the touch surface.

12. The method according to claim 11, wherein securing the sensor (108) to the second face (106) of the element (102) includes bonding the sensor (108) against the second face (106) of the element (102).

13. The method according to claim 11, wherein providing the element (102) and securing the sensor (108) to the second face (107) of the element (102) includes:
- positioning the sensor (108) on a support;
- thermoforming or injection moulding the element (102), during which the sensor (108) is positioned against the second face (107), and at the end of which the sensor (108) is integrated into the element (102).
